Europäisches Patentamt

European Patent Office

Office européen des brevets

(11) Numéro de publication: **0 048 200**
**B1**

(12) **FASCICULE DE BREVET EUROPEEN**

(45) Date de publication du fascicule du brevet: 02.05.85

(51) Int. Cl.⁴: **H 04 B 7/12,** H 04 B 7/02, H 03 J 7/28

(21) Numéro de dépôt: 81401399.1

(22) Date de dépôt: 08.09.81

(54) Dispositif de recherche de la fréquence d'accord d'un récepteur radioélectrique à modulation de fréquence.

(30) Priorité: 16.09.80 FR 8019918

(43) Date de publication de la demande:
24.03.82 Bulletin 82/12

(45) Mention de la délivrance du brevet:
02.05.85 Bulletin 85/18

(84) Etats contractants désignés:
DE GB

(56) Documents cités:
DE-A-2 840 533
FR-A-2 290 797
US-A-3 486 118
US-A-4 197 500

PROCEEDINGS OF THE IEE, vol. 122, no. 8, aoÛt 1975 STEVENAGE, HRTS (GB) PARSONS: "Experimental switched diversity system for v.h.f. a.m. mobile radio" pages 780-784

(73) Titulaire: THOMSON-CSF
173, Boulevard Haussmann
F-75379 Paris Cedex 08 (FR)

(72) Inventeur: Granek, Roger
THOMSON-CSF SCPI 173, bld Haussmann
F-75360 Paris Cedex 08 (FR)
Inventeur: Hybre, Jean
THOMSON-CSF SCPI 173, bld Haussmann
F-75360 Paris Cedex 08 (FR)
Inventeur: Drobecq, Michel
THOMSON-CSF SCPI 173, bld Haussmann
F-75360 Paris Cedex 08 (FR)

(74) Mandataire: Weinmiller, Jürgen et al
Zeppelinstrasse 63
D-8000 München 80 (DE)

(56) Documents cités:
IEEE TRANSACTIONS ON VEHICULAR TECHNOLOGY, vol. VT-22, no. 3, aoÛt 1973 NEW YORK (US) BITLER et STEVENS: "A UHF mobile telephone system using digital modulation: Preliminary study" pages 78-81

Courier Press, Leamington Spa, England.

## Description

La présente invention concerne un dispositif de recherche de la fréquence d'accord d'un récepteur radioélectrique à modulation de fréquence, et plus particulièrement un dispositif de recherche de la fréquence d'accord d'un récepteur radioélectrique à modulation de fréquence mobile par rapport à des stations émettrices émettant à des fréquences différentes.

Un tel dispositif peut être utilisé, par exemple, dans un système de liaison par radio entre un train et des stations fixes réparties le long de la voie ferrée. Les fréquences d'émission possibles sont par exemple au nombre de trois, et deux stations fixes consécutives émettent à des fréquences différentes. Lorsque le récepteur monté sur le train parcourt l'intervalle entre deux stations, il doit à un moment donné être commandé pour ne plus recevoir la fréquence de la station qu'il a quittée et recevoir la fréquence de la prochaine station.

Pour cela un récepteur comporte classiquement différents oscillateurs locaux fournissant les différentes fréquences d'accord correspondant aux différentes fréquences d'émission, le choix entre ces différents oscillateurs locaux étant effectué au moyen d'un dispositif de recherche de fréquence d'accord.

Le fonctionnement du dispositif de recherche de fréquence d'accord est généralement basé soit sur un repérage de la fréquence d'accord pour laquelle l'intensité du champ radioélectrique est maximum, un tel dispositif étant décrit par exemple dans la demande de brevet allemand DE—A—28 40 533, soit en effectuant un contrôle de la qualité du signal démodulé.

Dans un dispositif de recherche de fréquence d'accord connu, le contrôle de la qualité du signal démodulé se fait en isolant le bruit du signal utile, puis en mesurant la durée pendant laquelle le niveau du bruit est supérieur à un certain seuil. Si cette durée excède un certain seuil, on décide d'effectuer la commutation d'un oscillateur local sur un autre.

La mise en oeuvre de cette méthode nécessite donc un filtre passebande pour sélectionner le bruit en dehors de la bande du signal utile, un détecteur de seuil pour sélectionner le bruit dont le niveau est supérieur à un certain seuil, un générateur d'horloge associé à une porte "ET" pour rendre possible la mesure de la durée du bruit sélectionné par le détecteur de seuil et un système de compteurs pour mesurer cette durée et la comparer à une valeur de seuil.

La présente invention a pour but un dispositif de recherche de fréquence d'accord, de mise en oeuvre simplifiée, et dans lequel le contrôle de la qualité du signal démodulé s'effectue de manière totalement différente.

L'invention consiste en effet à tirer parti d'un phénomène considéré habituellement comme un phénomène parasitaire et de ce fait indésirable. Ce phénomène est connu sous le nom de "clicks" et est décrit notamment dans l'ouvrage de S. O. Rice, intitulé Time Series Analysis (E.d.M. Rosenblatt, pages 395—422, Wiley 1963).

Dans un démodulateur asynchrone, à partir du seuil de démodulation, des impulsions de bruit, appelées "clicks", apparaissent. Ces impulsions sont produites par un brusque passage en quadrature du bruit et du signal utile. Leur amplitude, théoriquement infinie, est en pratique très supérieure à celle du bruit et du signal utile et leur nombre est inversement proportionnel au rapport signal à bruit en moyenne fréquence.

La mesure de la fréquence de ces impulsions de bruit permet donc de connaître le rapport signal démodulé à bruit. Et pour comparer le rapport signal à bruit en basse fréquence sur différentes fréquences il suffit de comparer la fréquence de ces impulsions de bruit, la fréquence d'accord recherchée correspondant à celle pour laquelle cette fréquence est minimale.

De manière plus précise, l'invention concerne un dispositif de recherche de fréquence d'accord pour récepteur radioélectrique à modulation de fréquence, mobile par rapport à des stations émettrices émettant à des fréquences d'émission différentes, le récepteur comportant un démodulateur asynchrone muni de moyens pour synthétiser différentes fréquences d'accord correspondant aux différentes fréquences d'émission, caractérisé en ce qu'il comporte des moyens de comptage pour compter pour chaque fréquence d'accord et pendant une durée T, le nombre d'impulsions apparaissant en sortie du démodulateur asynchrone, lorsque la phase du signal résultant de l'addition du signal utile à la composante instantanée du bruit a une valeur multiple de

$$\frac{\pi}{2},$$

et des moyens de repérage pour repérer la fréquence d'accord pour laquelle le nombre d'impulsions apparaissant en sortie du modulateur asynchrone est minimum, cette fréquence étant la fréquence d'accord recherchée, les moyens de repérage fournissant le signal de commande des moyens pour synthétiser les différentes fréquences d'accord.

Selon une autre caractéristique de l'invention, le dispositif de recherche de fréquence d'accord comporte des moyens pour intégrer les résultats fournis par les moyens de comptage relativement à chaque fréquence d'accord, intercalés entre les moyens de comptage et les moyens de repérage.

Selon une autre caractéristique de l'invention, le dispositif de fréquence d'accord comporte des moyens pour activer les moyens de comptage, d'intégration et de repérage, à une fréquence f.

Les objets et caractéristiques de la présente invention apparaîtront plus clairement à la lecture de la description suivante d'exemples de réalisation, ladite description étant faite en relation avec les dessins ci-annexés, dans lesquels:

— la figure 1 est un schéma d'un récepteur radioélectrique comportant un dispositif de recherche de fréquence d'accord conforme à l'invention;

— la figure 2 est un algorithme qui représente la succession des différentes étapes du traitement effectué par le dispositif de recherche de fréquence d'accord conforme à l'invention.

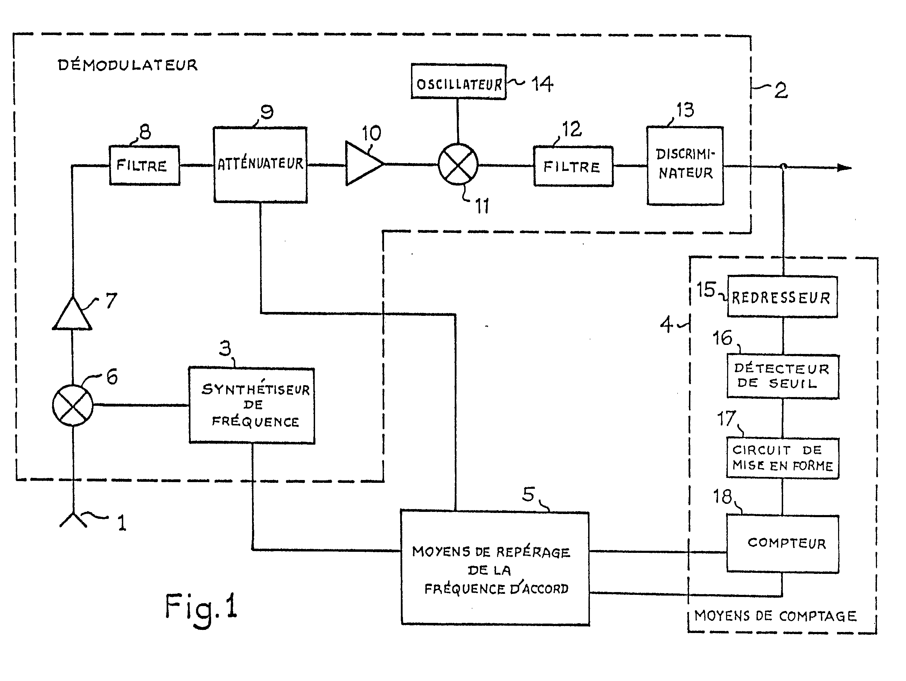

Le récepteur radioélectrique représenté sur la figure 1 comporte à la suite de l'antenne de réception 1, un démodulateur 2, muni d'un synthétiseur de fréquence 3 apte à générer différentes fréquences d'accord correspondant aux différentes fréquences d'émission, et un dispositif de recherche de fréquence d'accord comportant lui-même des moyens 4 de comptage d'impulsions de bruit, connectés en sortie du démodulateur et des moyens 5 de repérage de la fréquence d'accord pour laquelle le nombre d'impulsions de bruit est minimum, insérés entre la sortie des moyens de comptage 4 et l'entrée de commande du synthétiseur 3.

Le démodulateur 2 comporte à la suite de l'antenne 1 un premier mélangeur 6 destiné à faire subir au signal reçu un premier changement de fréquence. Le signal nécessaire à ce changement de fréquence provient du synthétiseur de fréquences 3.

Le premier mélangeur 6 est suivi d'un premier amplificateur 7, d'un premier filtre passe-bande 8, d'un atténuateur 9, d'un second amplificateur 10, d'un second mélangeur 11, d'un second filtre passe-bande 12, et d'un discriminateur 13.

Le signal obtenu en sortie du discriminateur est le signal d'entrée démodulé.

Le signal nécessaire au second changement de fréquence effectué par le second mélangeur 11 provient d'un oscillateur local 14. Le synthétiseur de fréquences 3 et l'atténuateur 9 sont commandés par le dispositif de recherche de fréquence d'accord.

L'atténuateur permet de remonter le niveau du bruit par rapport à celui du signal utile, et de se ramener dans une zone où la mesure du rapport signal à bruit est possible, donc d'augmenter la dynamique de mesure du dispositif de commande de recherche de fréquence.

Le dispositif de recherche de fréquence d'accord comporte des moyens 4 pour compter pendant une durée T et pour chaque fréquence d'accord, le nombre d'impulsions de bruit apparaissant en sortie du démodulateur, et des moyens 5 pour repérer la fréquence d'accord pour laquelle le nombre d'impulsions de bruit est minimum, cette fréquence étant la fréquence d'accord recherchée.

Les moyens de comptage comportent un redresseur 15 qui reçoit le signal de sortie du démodulateur, un détecteur de seuil 16 qui reçoit le signal de sortie du redresseur, un circuit 17 de mise en forme des signaux fournis par le détecteur de seuil 16, et un compteur 18 incrémenté au rythme du signal fourni par le circuit de mise en forme 17 et commandé par le signal fourni par les moyens de repérage 5. Les moyens de repérage 5 sont constitués par un microprocesseur qui commande et exploite les mesures effectuées par les moyens de comptage 4.

Le dispositif de recherche de fréquence d'accord fonctionne de la façon suivante.

Le signal présent à l'entrée du redresseur 15 est la superposition du signal utile démodulé, de bruit et d'impulsions de bruit. Conformément à l'invention, ce signal est exploité tel quel, sans aucun traitement préalable, par le dispositif de recherche 4.

Le dispositif de recherche selon l'invention étant basé sur une exploitation des impulsions de bruit, et ces impulsions pouvant être positives ou négatives, le signal de sortie du démodulateur est préalablement redressé au moyen du redresseur 15 de manière à avoir par la suite un traitement uniforme quelle que soit la polarité de ces impulsions.

Le détecteur de seuil 16 est destiné à détecter les impulsions de bruit à l'intérieur du signal fourni par le redresseur 15. Cette détection peut en effet se faire suivant un critère de seuil, en raison de la grande différence existant entre l'amplitude de ces impulsions et l'amplitude du reste du signal. Le seuil choisi pour le détecteur 16 tient compte de cet ordre de grandeur, et de ce fait est placé relativement haut.

Le circuit de mise en forme 17 est destiné à mettre les impulsions de bruit retenues par le détecteur 16 sous une forme exploitable par le compteur 18, c'est-à-dire sous la forme rectangulaire. Ainsi le compteur 18 compte le nombre d'impulsions de bruit apparaissant sur le signal démodulé.

Dans l'exemple de réalisation décrit, le repérage est effectué à l'aide d'un microprocesseur qui exploite les résultats fournis par les moyens de comptage 4.

Le microprocesseur effectue également une intégration des résultats fournis par les moyens de comptage relativement à chaque fréquence d'accord.

C'est également le microprocesseur qui active les moyens de comptage, d'intégration et de repérage, à une fréquence f qu'il est capable de modifier en fonction des résultats des mesures précédentes.

Enfin le microprocesseur réinitialise les moyens de comptage à la fréquence

$$\frac{1}{T}.$$

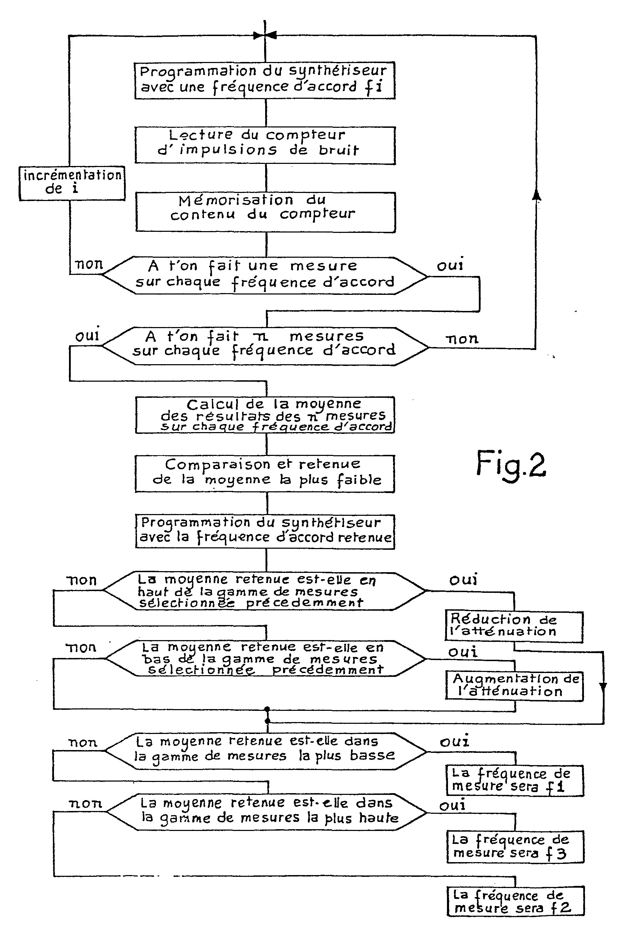

Le microprocesseur 5 est programmé conformément à l'algorithme représenté à la figure 2 que l'on décrit maintenant.

Cet algorithme débute par la programmation du synthétiseur de fréquences 3 avec l'une des fréquences d'accord $f_i$ possibles. Pour cette fréquence d'accord $f_i$, le microprocesseur autorise le comptage du compteur 18 pendant une durée T, puis mémorise le contenu du compteur 18 à la fin de cette période T.

Le même traitement est ensuite effectué pour la fréquence d'accord $f_{i+1}$, et ainsi de suite pour toutes les fréquences d'accord.

Puis on recommence n fois de suite le même traitement pour toutes les fréquences d'accord de manière à faire une intégration des résultats obtenus pour chaque fréquence d'accord.

Le microprocesseur effectue alors la moyenne des résultats obtenus pour les n mesures relatives à chaque fréquence d'accord et compare ces différentes fréquences moyennes pour retenir la plus faible. La fréquence moyenne la plus faible correspond en effet à celle pour laquelle la fréquence moyenne des impulsions de bruit est minimale, c'est-à-dire à la fréquence d'accord recherchée.

Le synthétiseur de fréquence 3 est alors programmé, avec la fréquence d'accord retenue.

Puis le microprocesseur procède à la détermination des conditions de mesure relatives aux prochaines mesures, c'est-à-dire à la détermination de la fréquence des mesures suivantes, et de l'atténuation procurée par l'atténuateur 9.

Pour cela, le microprocesseur fait un certain nombre de tests sur la fréquence moyenne retenue précédemment.

Un premier test consiste à situer la fréquence moyenne retenue à l'intérieur d'une gamme de mesures, une gamme de mesures comportant toutes les fréquences comprises entre une limite inférieure et une limite supérieure de fréquence moyenne des impulsions de bruit.

Un second test consiste à situer la gamme de mesure retenue à l'intérieur d'un ensemble de gammes de mesure qui sont juxtaposées de manière à couvrir une zone de fréquences plus ou moins étendue selon le nombre de gammes choisi.

Le premier test a pour but de sélectionner l'atténuation que devra procurer l'atténuation 9 lors des prochaines mesures.

Le second test a pour but de déterminer la fréquence des prochaines mesures.

Les deux paramètres: atténuation et fréquence des mesures suffisent à déterminer la gamme de mesures dans laquelle vont se situer les prochaines mesures.

Au cours du premier test, on compare la fréquence moyenne retenue avec les limites supérieure et inférieure de la gamme de mesures sélectionnée précédemment. Si la fréquence moyenne retenue est proche de la limite supérieure de la gamme de mesures sélectionnée précédemment, on décide de réduire l'atténuation procurée par l'atténuateur pour les prochaines mesures. Si au contraire, la fréquence moyenne retenue est proche de la limite inférieure de la gamme de mesures sélectionnée précédemment, on décide d'augmenter cette atténuation.

Au cours du second test, on recherche si la fréquence moyenne retenue se trouve dans la gamme de mesures la plus basse.

On entend par gamme de mesures la plus basse celle où les valeurs de fréquence moyenne d'impulsions de bruit sont les plus élevées.

Si tel est le cas, on décide que la fréquence des prochaines mesures sera la fréquence la plus élevée, c'est-à-dire $f_1$. En effet, si la fréquence moyenne des impulsions de bruit retenue est trop forte, cela signifie que l'on est dans une zone de transition entre les différentes fréquences d'émission, donc que les mesures doivent se renouveler assez rapidement pour trouver le plus vite possible la fréquence d'accord correspondant à la nouvelle fréquence d'émission.

Si tel n'est pas le cas on cherche si la fréquence moyenne retenue se trouve dans la gamme de mesures la plus haute. On entend par gamme de mesures la plus haute celle où les valeurs de fréquence moyenne des impulsions de bruit sont les plus faibles.

Si la fréquence moyenne retenue se trouve dans la gamme de mesures la plus haute, on décide que la fréquence des prochaines mesures sera la fréquence la plus faible, c'est-à-dire $f_3$.

En effet, si la fréquence moyenne des impulsions de bruit retenue est très faible, cela signifie que le récepteur se trouve dans une zone où les interférences avec d'autres fréquences d'émission ne se fait pas encore sentir, et où par conséquent il n'est pas nécessaire de renouveler fréquemment les mesures.

Si maintenant la fréquence moyenne retenue ne se trouve ni dans la gamme de mesures la plus basse, ni dans la gamme de mesures la plus haute, on décide que la fréquence des prochaines mesures sera une fréquence $f_2$ intermédiaire entre les fréquences $f_1$ et $f_3$.

L'algorithme décrit ci-dessus se répète ainsi à la fréquence de mesures sélectionnée.

La possibilité de faire varier le taux d'atténuation du signal mesuré et la fréquence des mesures permet d'améliorer sensiblement la qualité et l'opportunité des mesures.

**Revendications**

1. Dispositif de recherche de fréquence d'accord pour récepteur radioélectrique à modulation de fréquence, mobile par rapport à des stations émettrices émettant à des fréquences d'émission différentes, le récepteur comportant un démodulateur asynchrone (2) muni de moyens (3) pour synthétiser différentes fréquences d'accord correspondant aux différentes fréquences d'émission, caractérisé en ce qu'il comporte des moyens de comptage (4) pour compter pour chaque fréquence d'accord, et pendant une durée T, le nombre d'impulsions apparaissant en sortie du démodulateur asynchrone, lorsque la phase du signal résultant de l'addition du signal utile à la composante instantanée du bruit a une valeur multiple de

$$\frac{\pi}{2},$$

et des moyens de repérage (5) pour repérer la fréquence d'accord pour laquelle le nombre d'impulsions apparaissant en sortie du modulateur asynchrone est minimum, cette fréquence étant la fréquence d'accord recherchée, les moyens de repérage fournissant le signal de commande des moyens (3) pour synthétiser les différentes fréquences d'accord.

2. Dispositif selon la revendication 1, caractérisé en ce que les moyens de comptage (4) comportent un redresseur (15) connecté en sortie du démodulateur, un détecteur de seuil (16) connecté en sortie du redresseur (15), un circuit de mise en forme (17) connecté en sortie du détecteur de seuil (16), et un compteur (18) incrémenté par le signal de sortie du circuit de mise en forme (17), et réinitialisé par un signal d'horloge de fréquence

$$\frac{1}{T}.$$

3. Dispositif selon l'une des revendications 1 ou 2, caractérisé en ce que les moyens de repérage (5) intègrent les résultats fournis par les moyens de comptage (4) relativement à chaque fréquence d'accord.

4. Dispositif selon les revendications 1 et 2 ou 2 et 3, caractérisé en ce que les moyens de repérage (5) activent les moyens de comptage (4), à une fréquence f.

5. Dispositif selon la revendication 4, caractérisé en ce que la fréquence f est variable en fonction des résultats fournis par les moyens de repérage (5).

6. Dispositif selon l'une quelconque des revendications 1, 2, 3, 4 ou 5, dans lequel le démodulateur (2) comporte un atténuateur (9) apte à rehausser le niveau du bruit par rapport à celui du signal utile, caractérisé en ce qu'il comporte des moyens (5) pour commander l'atténuateur (9) en fonction des résultats fournis par les moyens de repérage.

**Patentansprüche**

1. Abstimmfrequenz-Suchvorrichtung für einen in Bezug auf Sendestationen, die auf verschiedenen Sendefrequenzen senden, mobilen Frequenzmodulations-Funkempfänger, der einen asynchronen Demodulator (2) aufweist, welcher mit Einrichtungen (3) zur synthetischen Erzeugung von verschiedenen Abstimmfrequenzen versehen ist, die den verschiedenen Sendefrequenzen entsprechen, dadurch gekennzeichnet, daß sie Zählmittel (4) umfaßt, um für jede Abstimmfrequenz und während einer Dauer T die Anzahl von Impulsen zu zählen, welche am Ausgang des asynchronen Demodulators auftreten, wenn die Phase des Signals, das aus der Addition des Nutzsignals mit der Augenblickskomponente des Rauschens resultiert, einen Wert aufweist, der ein Vielfaches von

$$\frac{\pi}{2}$$

ist, und Auffindemittel (5) umfaßt, um die Abstimmfrequenz aufzufinden, für welche die Anzahl von am Ausgang des asynchronen Modulators erscheinenden Impulsen minimal ist, wobei diese Frequenz die gesuchte Abstimmfrequenz ist und wobei die Aufsuchmittel das Steuersignal für die Einrichtungen (3) zum synthetischen Erzeugen der verschiedenen Abstimmfrequenzen liefern.

2. Vorrichtung nach Anspruch 1, dadurch gekennzeichnet, daß die Zählmittel (4) einen Gleichrichter (15), der an den Ausgang des Demodulators angeschlossen ist, einen an den Ausgang des Gleichrichters (15) angeschlossenen Schwellwertdetektor (16), eine Formgebungsschaltung (17), die an den Ausgang des Schwellwertdetektors (16) angeschlossen ist, und einen Zähler (18) umfassen, welcher durch das Ausgangssignal der Formgebungsschaltung (17) inkrementiert und durch ein Taktsignal der Frequenz

$$\frac{1}{T}$$

neu initiiert wird.

3. Vorrichtung nach Anspruch 1 oder 2, dadurch gekennzeichnet, daß die Auffindemittel (5) die von den Zählmitteln (4) gelieferten Ergebnisse für jede Abstimmfrequenz integrieren.

4. Vorrichtung nach den Ansprüchen 1 und 2 oder 2 und 3, dadurch gekennzeichnet, daß die Auffindemittel (5) die Zählmittel (4) bei einer Frequenz f aktivieren.

5. Vorrichtung nach Anspruch 4, dadurch gekennzeichnet, daß die Frequenz f variabl ist in Abhängigkeit von den Ergebnissen, die von den Auffindemitteln (5) geliefert werden.

6. Vorrichtung nach einem der Ansprüche 1, 2, 3, 4 und 5, bei welcher der Demodulator (2) ein Dämpfungsglied (9) umfaßt, das geeignet ist, um den Rauschpegel gegenüber dem des Nutzsignals anzuheben, dadurch gekennzeichnet, daß sie Mittel (5) umfaßt, um das Dämpfungsglied (9) in Abhängigkeit von den Ergebnissen, die von den Auffindemitteln geliefert werden, zu steuern.

**Claims**

1. Tuning-frequency search device for a frequency modulation radio receiver which is mobile with respect to transmitter stations transmitting on different transmission frequencies, the receiver comprising an asynchronous demodulator (2) provided with frequency synthesizer means (3) for generating different tuning frequencies corresponding to the different transmission frequencies, characterized in that it comprises counter means (4) for counting for each tuning frequency and for a duration T the number of pulses appearing at the output of the asynchronous demodulator when the phase of the signal resulting from the addition of the useful signal to the momentary noise component has a value which is a multiple of

$$\frac{\pi}{2},$$

and recognizing means (5) for recognizing the tuning frequency for which the number of pulses appearing at the output of the asynchronous demodulator is minimum, this frequency being the desired tuning frequency, the recognizing means supplying the control signal of the different tuning frequencies synthesizer means (3).

2. Device according to claim 1, characterized in that the counter means (4) comprise a rectifier (15) connected to the output of the demodulator, a threshold detector (16) connected to the output of the rectifier (15), a shaping circuit (17) connected to the output of the threshold detector (16) and a counter (18) incremented by the output signal of the shaping circuit (17) and reinitialized by a clock signal of the frequency

$$\frac{1}{T}.$$

3. Device according to any of claims 1 and 2, characterized in that the recognizing means (5) integrate the results supplied by the counter means (4) for each tuning frequency.

4. Device according to claims 1 and 2 or 2 and 3, characterized in that the recognizing means (5) activate the counter means (4) at a frequency f.

5. Device according to claim 4, characterized in that the frequency f is variable in function of the results supplied by the recognizing means (5).

6. Device according to any of claims 1, 2, 3, 4 or 5, wherein the demodulator (2) comprises an attenuator (9) adapted to raise the noise level with respect to the level of the useful signal, characterized in that it comprises means (5) for controlling the attenuator (9) in dependence upon the results supplied by the recognizing means.

Fig.1

DÉMODULATEUR

OSCILLATEUR ~ 14

8
FILTRE

9
ATTÉNUATEUR

10

11

12
FILTRE

13
DISCRIMI-
NATEUR

~ 2

7

3
SYNTHÉTISEUR
DE
FRÉQUENCE

6

1

5
MOYENS DE REPÉRAGE
DE LA
FRÉQUENCE D'ACCORD

15 ~ REDRESSEUR

4 ~

16
DÉTECTEUR
DE SEUIL

17
CIRCUIT DE
MISE EN FORME

18
COMPTEUR

MOYENS DE COMPTAGE

0 048 200

Fig.2